# EUROPEAN PATENT APPLICATION

(11) **EP 1 076 389 A1**
(43) Date of publication of application: **14.02.2001**
(21) Application number: 99954370.5
(22) Date of filing: 04.11.1999
(51) Int. Cl.: H01S 5/223

(54) **SURFACE-EMITTING SEMICONDUCTOR LASER**

(30) Priority: 04.11.1998 JP 31341498
(71) Applicant: The Furukawa Electric Co., Ltd., Tokyo 100-8322 (JP)
(72) Inventor: MUKAIHARA, Toshikazu, The Furukawa Electric Co.Ltd, Tokyo 100-8322 (JP); IWAI, Norihiro, The Furukawa Electric Co., Ltd, Tokyo 100-8322 (JP); KASUKAWA, Akihiko, The Furukawa Electric Co., Ltd, Tokyo 100-8322 (JP)
(74) Representative: Modiano, Guido, Dr.-Ing.
(86) International application number: JP9906137
(87) International publication number: WO0027003

(57) **Abstract**

In a surface emitting semiconductor laser device, an active layer and a current blocking layer arranged near the active layer are both arranged between two reflecting mirror layer structures. The current blocking layer is an AlInAs layer having an oxidized region formed at its peripheral portion. The surface emitting semiconductor laser device operates with a low threshold current, and can operate continuously in a high temperature.

## Description

### Technical Field

The present invention relates to a surface emitting semiconductor laser device, more specifically, a surface emitting semiconductor laser device that operates with a threshold current lower than that of a conventional one and operates continuously in a high temperature.

### Background Art

In recent years, research is being made to construct a mass optical communication network or create an optical interconnection system or an optical computing system. As a light source of those systems, a high integrated-semiconductor laser array device is indispensable.

Here, the device structure of a conventional surface emitting semiconductor laser device as an example of high integrated-semiconductor laser array device and the process of manufacturing it will be described based on drawings.

The conventional surface emitting semiconductor laser device is manufactured as follows:

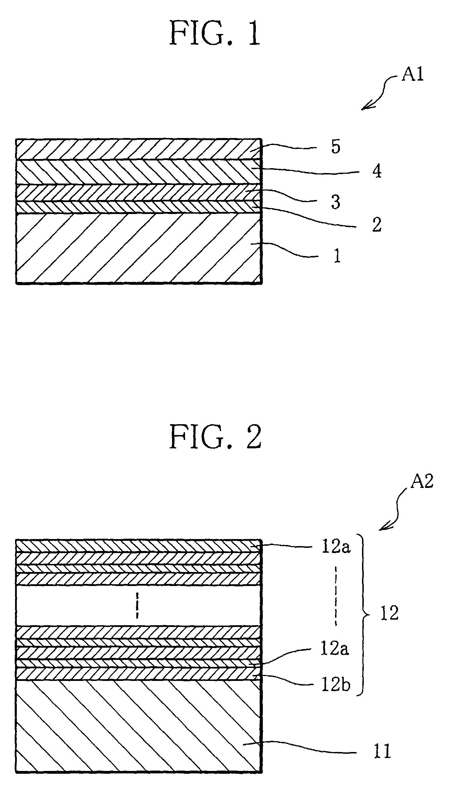

First, by the MOCVD method, an etching stop layer 2 of GaInAs, a cladding layer 3 of p-InP, a quantum well active layer 4 and a cladding layer 5 of n-InP are formed on an InP substrate 1 in this order. Thus, a stacked structure A1 as shown in FIG. 1 is formed.

On the other hand, on an n-GaAs substrate 11, by the MBE method, an n-GaAs layer 12a and an n-AlAs layer 12b each having a thickness of λ/4n (λ: emission wavelength, n: integer) are formed alternately 27 periods. Thus, a stacked structure A2 including a first reflecting mirror layer structure 12 as shown in FIG. 2 is formed.

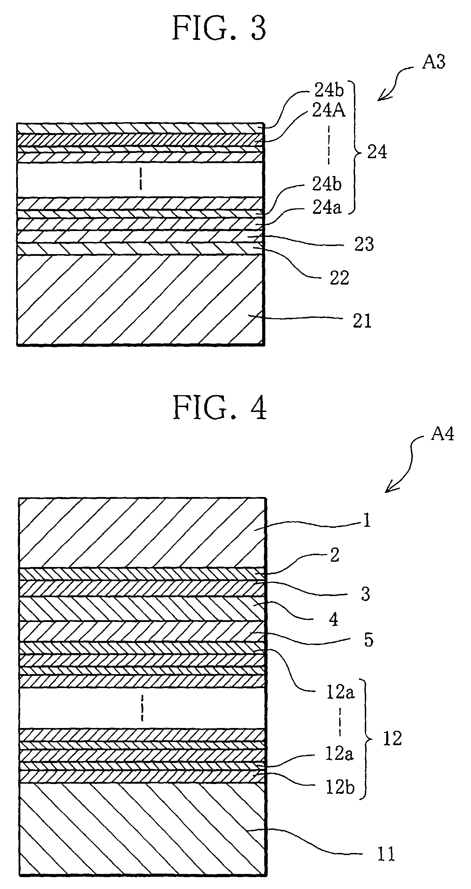

Further, by the MBE method, an etching stop layer 22 of AlAs and a contact layer 23 of p-GaAs are formed on a GaAs substrate 21, and on the contact layer 23, a p-AlGaAs layer 24a and a p-GaAs layer 24b each having a thickness of λ/4n are formed alternately 27 periods. Thus, a stacked structure A3 including a second reflecting mirror layer structure 24 as shown in FIG. 3 is formed. Here, a composition graded layer may be inserted between each p-GaAs layer 24b and p-AlGaAs layer 24a to reduce resistance.

In the reflecting mirror layer structure 24 of the stacked structure A3, the p-AlGaAs layer 24A directly under the uppermost p-GaAs layer 24b undergoes a treatment described later so that it may function as a current blocking layer. For this reason, it has a higher Al rate of composition than that of the other p-AlGaAs layers 24a.

Next, the surface of the cladding layer 5 of the stacked structure A1 and the surface of the first reflecting mirror layer structure 12 are treated with hydrofluoric acid. Then, in an atmosphere of a room temperature, both are stacked having those surfaces in close contact with each other, and then heat-treated in a hydrogen atmosphere of 600°C in temperature.

As a result, as shown in FIG. 4, a stacked structure A4 is obtained in which the cladding layer 5 of the stacked structure A1 and the reflecting mirror layer structure 12 stick together.

Then, the InP substrate 1 of the stacked structure A4 is removed by etching with hydrochloric acid, and then the GaInAs etching stop layer 2 is removed by etching with a sulphuric acid etchant so that the p-InP cladding layer 3 may be exposed.

Then, the surface of the exposed p-InP cladding layer 3 and the surface of tile reflecting mirror layer structure 24 of the stacked structure A3 are treated with hydrofluoric acid. Then, in an atmosphere of a room temperature, both are stacked having those surfaces in close contact with each other, and then heat-treated in a hydrogen atmosphere of 600°C in temperature.

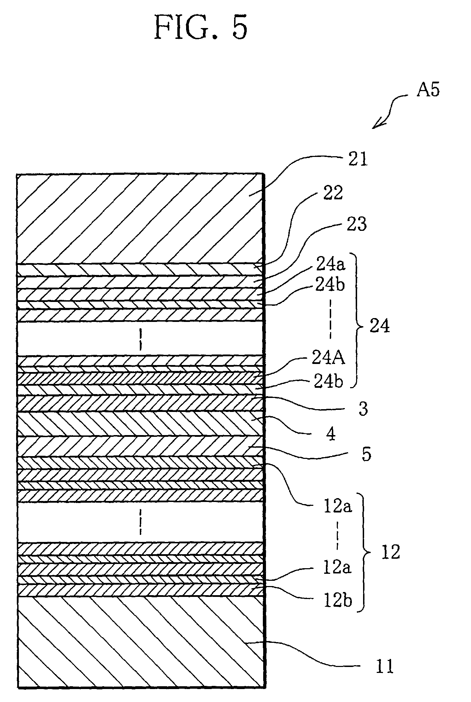

As a result, as shown in FIG. 5, a stacked structure A5 is obtained in which the cladding layer 3 of the stacked structure A4 and the p-GaAs layer 24b of the reflecting mirror layer structure 24 of the stacked structure A3 stick together and the active layer 4 is between the first reflecting mirror layer structure 12 and the second reflecting mirror layer structure 24.

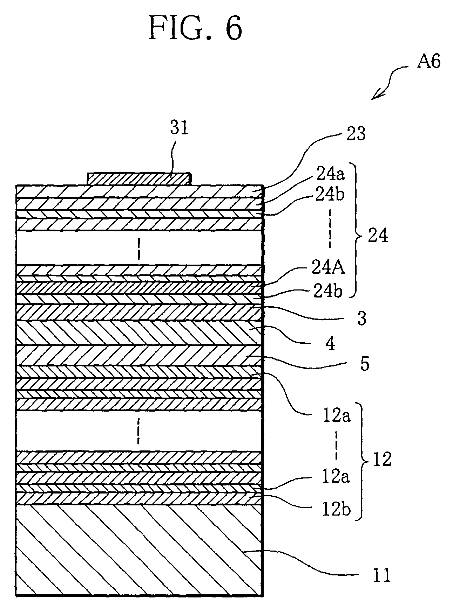

Then, the GaAs substrate 21 of the stacked structure A5 is removed by etching with a mixture of aqueous ammonia and aqueous hydrogen peroxide, and then the AlAs etching stop layer 22 is removed by etching with hydrofluoric acid so that the p-GaAs contact layer 3 may be exposed. Then, by using the photolithography and lift-off technique, for example, a p type electrode 31 of about 10µm in diameter having a multi layer structure of Ti/Pt/Au/Ni is formed at the surface of the exposed p-GaAs contact layer 23 as shown in FIG. 6. Thus, a stacked structure A6 is obtained.

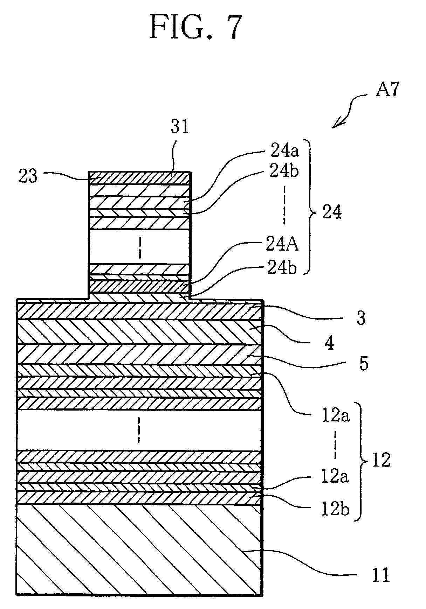

Then, part of the contact layer 23 and second reflecting mirror layer structure 24 is selectively removed by etching with chloride RIBE, using the uppermost Ni layer of the p type electrode 31 of the stacked structure A6 as a mask, to the extent that the side of the AlGaAs layer 24A of the second reflecting mirror layer structure is exposed. Thus, a stacked structure A7 having a mesa as shown in FIG. 7 is formed.

Thus, the side of the AlGaAs layer 24A having a higher Al rate of composition is exposed at the side of the mesa of the stacked structure A7.

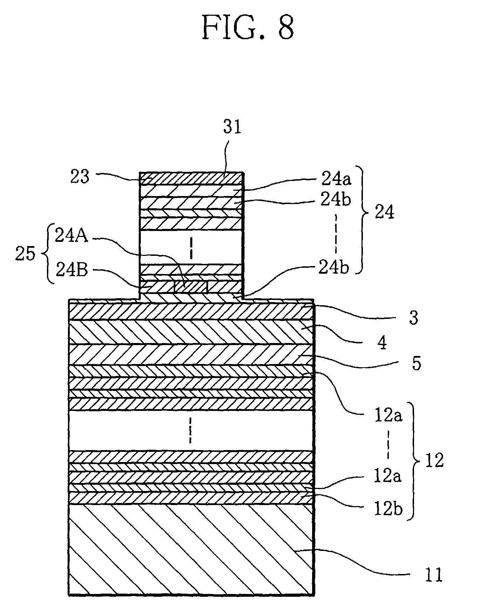

Next, the stacked structure A7 is heat-treated in a steam atmosphere for a predetermined time. In this process, oxidation of the p-AlGaAs layers 24a having a lower Al rate of composition and p-GaAs layers 24b does not go on, but in the p-AlGaAs layer 24A having a higher Al rate of composition, oxidation of Al goes on from the side to the center. As a result, as shown in FIG. 8, the p-AlGaAs layer 24A is converted into a current blocking layer 25 whose peripheral ring portion is an oxidized region 24B having electrical insulating Al oxide as a main component and whose central portion remains the non-oxidized p-AlGaAs layer 24A.

Here, the extent of the oxidized region 24B, therefore, the extent of the non-oxidized region 24A that can serve as a passage for injected current can be regulated by choosing the conditions of heat treatment appropriately.

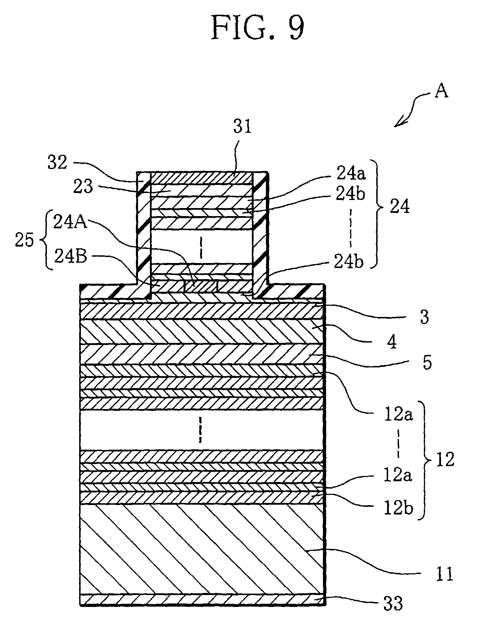

Then, an insulating film 32 of, for example, SiNx is formed on the entire surface, and a hole for use in injecting current into the p type electrode 31 is bored. Further, the rear surface of the GaAs substrate 11 is polished so that the thickness of the entire GaAs substrate 11 may be about 100µm, and then an n type ring electrode 33 of, for example, AuGeNi/Mo/Au is formed on the polished surface. Thus, the surface emitting semiconductor laser device A having a stacked structure shown in FIG. 9 is obtained.

In order for the semiconductor laser device to operate in a high temperature more stabily, the threshold current thereof needs to be lower. In order for the semiconductor laser device to have a lower threshold current, the distance between the current blocking layer 25 and the active layer of the device A needs to be shorter so that the injected current passing through the non-oxidized region 24B of the current blocking layer 25 may concentratedly act on the active layer 4.

However, actually, the injected current is diffused near the active layer 4, and a large proportion of the injected current does not directly contribute to the laser emission. In addition, the scattering loss of light in the oxidized region 24B of the current blocking layer 25 is large. Thus, it turned out that lowering the threshold current was difficult. Further, barrier is generated at the joint interface between the p-GaAs layer 24b and p-InP layer 3. The barrier causes further voltage on the injected holes, so that the current (holes) diffuses more easily.

The object of the invention is to solve the above problems of the conventional device A and provide a surface emitting semiconductor laser device having a shorter distance between the current blocking layer and the active layer than that of the conventional one, showing a good performance in confining current to near the active layer, decreasing ineffective current and scattering loss, therefore being able to operate with a low threshold current and operate continuously in a high temperature.

### Disclosure of the Invention

In order to attain the above object, the present invention provides
a surface emitting semiconductor laser device comprising:
an active layer and a current blocking layer arranged near the active layer, both of the active layer and the current blocking layer being arranged between two reflecting mirror layer structures; wherein
the current blocking layer is an AlInAs layer having an oxidized region formed at the peripheral portion thereof.

The present invention further provides a surface emitting semiconductor laser device in which the current blocking layer is arranged in a cladding layer arranged over or under the active layer, and a surface emitting semiconductor laser device in which a p type cladding layer of 30nm to 250nm in thickness is arranged between the current blocking layer and the active layer.

### Brief Description of the Drawings

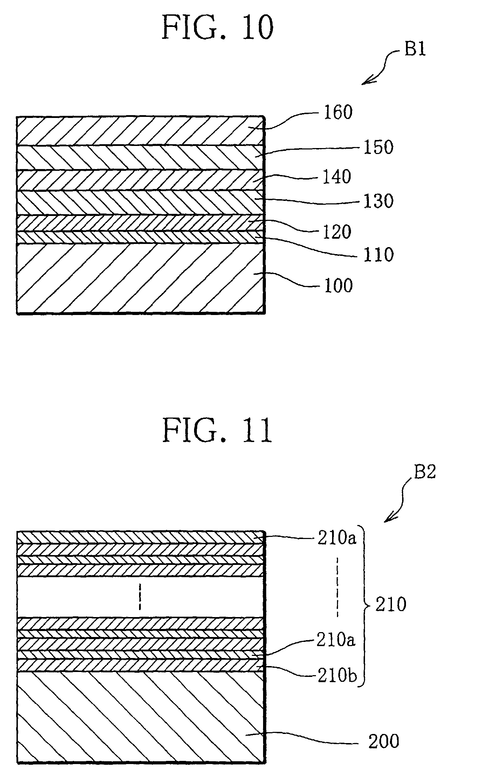

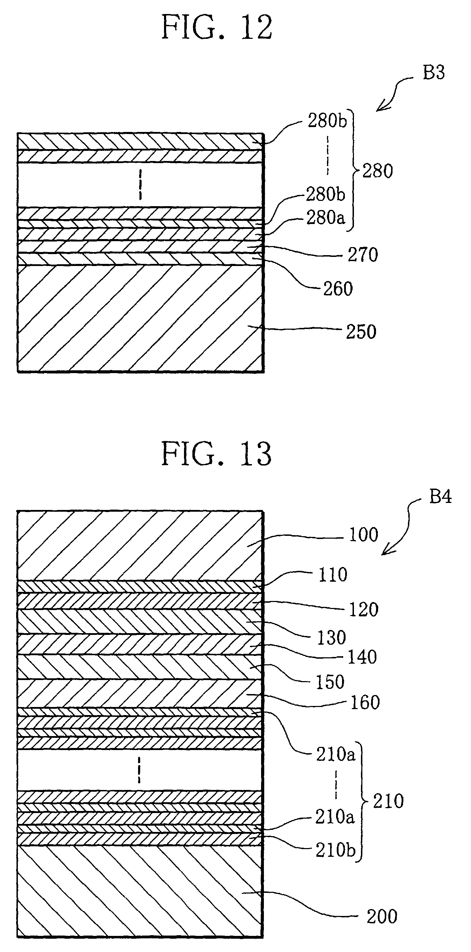

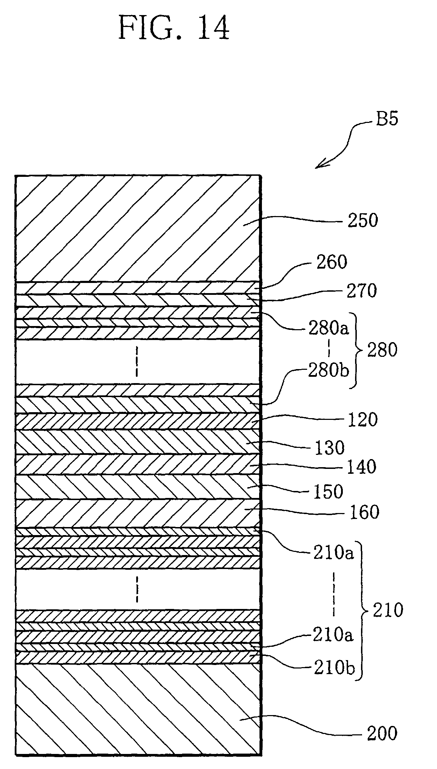

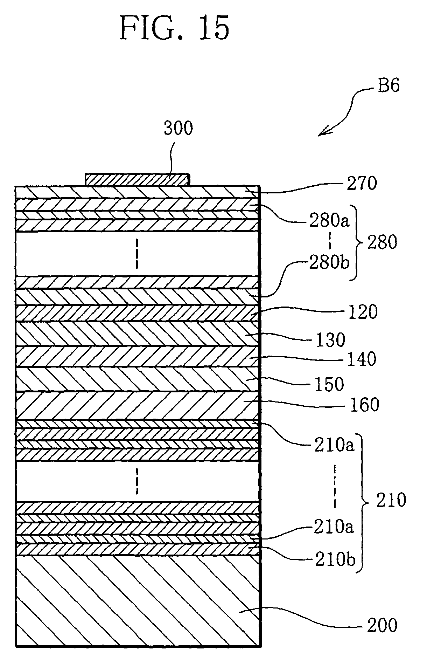

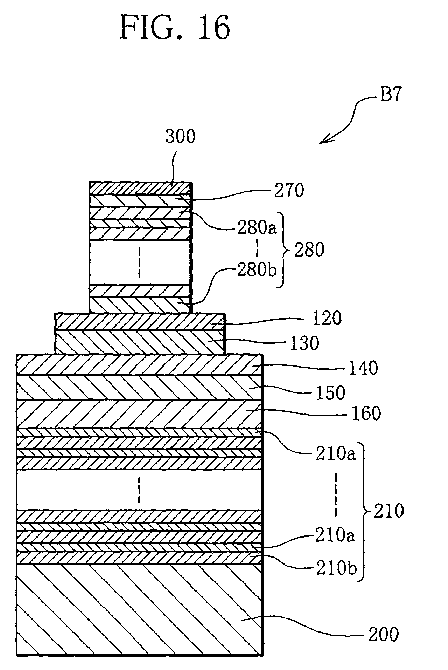

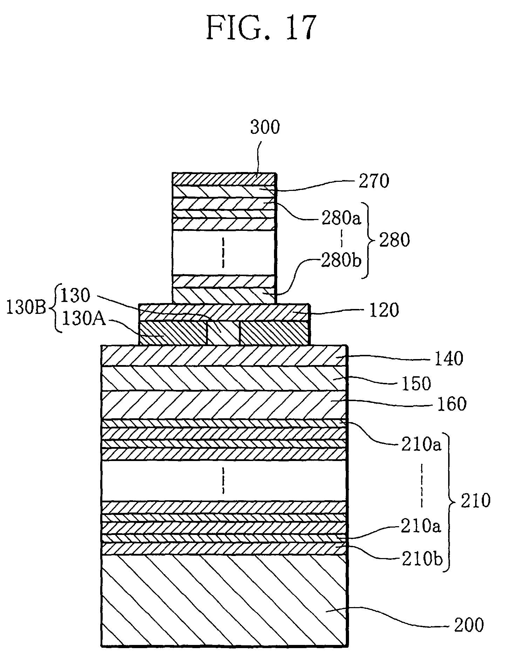

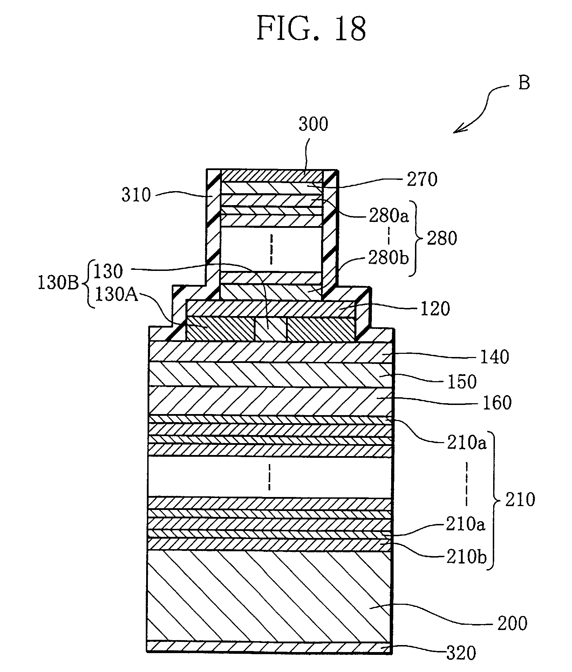

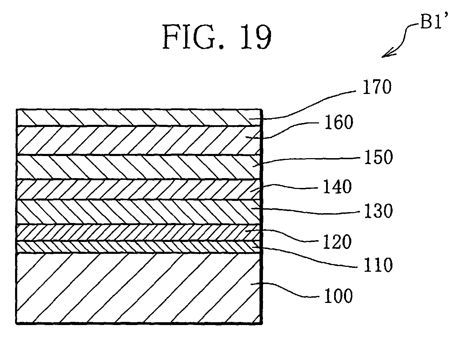

FIG. 1 is a cross-sectional view of a stacked structure A1 used in manufacturing a device having a conventional structure; FIG. 2 is a cross-sectional view of a stacked structure A2 used in manufacturing a device A; FIG. 3 is a cross-sectional view of a stacked structure AB3 used in manufacturing the device A; FIG. 4 is a cross-sectional view of a stacked structure A4 formed by sticking the stacked structures A1 and A2 together; FIG. 5 is a cross-sectional view of a stacked structure A5 formed by sticking the stacked structures A3 and A4 together; FIG. 6 is a cross-sectional view of a stacked structure A6 having a p type electrode formed on the stacked structure A5; FIG. 7 is a cross-sectional view of a stacked structure A7 having a mesa which is formed by etching the stacked structure A6; FIG. 8 is a cross-sectional view of the stacked structure A7 in which an AlGaAs layer is oxidized; FIG. 9 is a cross-sectional view of the conventional laser device A; FIG. 10 is a cross-sectional view of a stacked structure B1 used in manufacturing a device of the present invention; FIG. 11 is a cross-sectional view of a stacked structure B2 used in manufacturing the device of the present invention; FIG. 12 is a cross-sectional view of a stacked structure B3 used in manufacturing the device of the present invention; FIG. 13 is a cross-sectional view of a stacked structure B4 formed by sticking the stacked structures B1 and B2 together; FIG. 14 is a cross-sectional view of a stacked structure B5 formed by sticking the stacked structures B3 and B4 together; FIG. 15 is a cross-sectional view of a stacked structure B6 having a p type electrode formed on the stacked structure B5; FIG. 16 is a cross-sectional view of a stacked structure B7 having a mesa which is formed by etching the stacked structure B6; FIG. 17 is a cross-sectional view of the stacked structure B7 in which an AlInAs layer is oxidized; FIG. 18 is a cross-sectional view of the laser device B of the present invention; and FIG. 19 is a cross-sectional view of another stacked structure B1' usable in the present invention.

### Best Mode of Carrying out the Invention

The laser device of the present invention is manufactured in accordance with a process described later. The characteristics of the process are as follows:

In the process of manufacturing the conventional laser device A, a precursor that is to be converted into the current blocking layer is formed as the layer 24A of the second reflecting mirror layer structure 24 of the stacked structure A3 shown in FIG. 3. In contrast thereto, in the process of manufacturing the laser device of the present invention, the current blocking layer is formed in a stacked structure described later that corresponds to the stacked structure A1 shown in FIG. 1. It is not formed in a stacked structure having a second reflecting mirror layer structure.

Therefore, in the present invention, material for the precursor layer that is to be converted into the current blocking layer needs to be material that can lattice-match with the InP substrate of the stacked structure Al shown in FIG.1 and can produce an oxidized region. As such material, the inventors found AlInAs, and created the laser device of the present invention.

In the process of manufacturing the laser device of the present invention, first, as shown in FIG. 10, by the MOCVD method, an etching stop layer 110 of GaInAs, a cladding layer 120 of p-InP and a layer 130 of p-AlInAs are formed on an InP substrate 100 in this order, and then a cladding layer 140 of p-InP, a quantum well structured active layer 150 and a cladding layer 160 of n-InP are further formed in this order. Thus, a stacked structure B1 is formed.

Here, the layer 130 is a layer to be converted into a current blocking layer by undergoing a treatment described later. The thickness of the layer 130 may be about 50nm. The thicknesses of the cladding layers 140 and 160 arranged under and over the layer 130 are determined to be about 50nm and 250nm, respectively.

Further, as shown in FIG. 11, on an n-GaAs substrate 200, by the MBE method, an n-GaAs layer 210a and an n-AlAs layer 210b each having a thickness of λ/4n (λ: emitting wavelength, n: integer) are formed alternately 27 periods. Thus, a stacked structure B2 having a first reflecting mirror layer structure 210 is formed.

Further, by the MBE method, an etching stop layer 260 of AlAs and a contact layer 270 of p-GaAs are formed on a GaAs substrate 250, and then on the contact layer 270, a p-GaAs layer 280a and a p-AlGaAs layer 280b each having a thickness of λ/4n are formed alternately 27 periods. Thus, a stacked structure B3 having a second reflecting mirror layer structure 280 as shown in FIG. 12 is formed.

Next, the surface of the cladding layer 160 of the stacked structure B1 and the surface of the first reflecting mirror layer structure 210 are treated with hydrofluoric acid. Then, in an atmosphere of a room temperature, both are stacked having those surfaces in close contact with each other, and then heat-treated in a hydrogen atmosphere of 600°C In temperature.

As a result, as shown in FIG. 13, a stacked structure B4 is obtained in which the cladding layer 160 of the stacked structure B1 and the reflecting mirror layer structure 280 of the stacked structure B2 stick together, and the distance between the layer 130 and the active layer 150 is the thickness (50nm) of the cladding layer 140.

Then, the InP substrate 100 of the stacked structure B4 is removed by etching with hydrochloric acid, and then the GaInAs etching stop layer 110 is removed by etching with a sulphuric acid etchant so that the p-InP cladding layer 120 may be exposed. Then, the surface of the exposed p-InP cladding layer 120 and the surface of the second reflecting mirror layer structure 280 of the stacked structure B3 are treated with hydrofluoric acid. Then, in an atmosphere of a room temperature,
both are stacked having those surfaces in close contact with each other, and then heat-treated in a hydrogen atmosphere of 600°C in temperature.

As a result, as shown in FIG. 14, a stacked structure B5 is obtained in which the cladding layer 120 of the stacked structure B4 and the GaAs layer 280b of the reflecting mirror layer structure 280 of the stacked structure B3 stick together, the active layer 150 is between the first reflecting mirror layer structure 210 and the second reflecting mirror layer structure 280, and the p-AlInAs layer 130 of 200nm in thickness is arranged over the active layer 150 with the p-InP cladding layer 140 of 50nm in thickness between.

Then, the GaAs substrate 250 of the stacked structure B5 is removed by etching with a mixture of aqueous ammonia and aqueous hydrogen peroxide, and then the AlAs etching stop layer 260 is removed by etching with hydrofluoric acid so that the p-GaAs contact layer 270 may be exposed. Then, as shown in FIG. 15, by using the photolithography and lift-off technique, for example, a p type electrode 300 of about 10µm in diameter having a multi layer structure of Ti/Pt/Au/Ni is formed at the surface of the exposed p-GaAs contact layer 270. Thus, a stacked structure B6 is obtained.

Then, part of the second reflecting mirror layer structure 280 is selectively removed by etching with chloride RIBE, using the uppermost Ni layer of the p type electrode 300 of the stacked structure B6 as a mask. Then, using a resist pattern of a larger size , the p-InP layer 120 and the p-AlInAs layer 130 are removed. Thus, as shown in FIG. 16, a stacked structure B7 having a two-stage mesa is formed.

Thus, the side of the p-AlInAs layer 130 is exposed at the side of the mesa of the stacked structure 7.

Next, the stacked structure B7 is heat-treated in a steam atmosphere for a predetermined time. In this process, because of a resist mask (not shown), oxidation of the p-AlGaAs layers 280 of the second reflecting mirror layer structure 280 does not go on. However, in the p-AlInAs layer 130, oxidation of Al goes on from the exposed side to the center. As a result, as shown in FIG. 17, the p-AlInAs layer 130 is converted into a current blocking layer 130B whose peripheral ring portion is an oxidized region 130A having electrical insulating Al oxide as a main component and whose central portion remains the non-oxidized p-AlGaAs layer 130.

Here, the extent of the oxidized region 130A, therefore, the extent of the non-oxidized region 130 that can serve as a passage for injected current can be regulated by choosing the conditions of heat treatment appropriately.

It is desirable that the current blocking layer is provided in a cladding layer, especially a p type cladding layer arranged near the active layer. In that case, since the mobility of holes is smaller, more efficient current operation can be made.

Then, an insulating film 310 of, for example, SiNx is formed on the entire surface, and a hole for use in injecting current into the p type electrode 300 is bored. Further, the rear surface of the GaAs substrate 200 is polished so that the thickness of the entire GaAS substrate 200 may be about 100µm, and then an n type ring electrode 320 of, for example, AuGeNi/Mo/Au is formed on the polished surface. Thus, the laser device B of the present invention as shown in FIG. 18 is obtained.

In the laser device B, the thickness of the p-InP layer 140 between the current blocking layer 130B and the active layer 150 is about 50nm. Therefore, current injected from the p type electrode 300 is narrowed at the current blocking layer 130B and effciently acts on the active layer 150 without being diffused near the active layer 150.

Here, it is desirable that the thickness of the p-InP layer 140 is about 30 to 250nm, because in that case, in the vertical cavity consisting of the two reflecting mirror layer structures and the active layer, the current blocking layer 130B lies near a node of a standing wave of light. As a result, scattering loss of light is reduced, which makes it possible that the device operates with a low threshold current.

Thus, the laser device B operates with a threshold current lower that of the laser device A having a conventional structure, and can operate continuously in a high temperature.

In the process of manufacturing the laser device B shown in FIG. 18, the stacked structure B7 was heat-treated in a steam atmosphere of 500°C for 60 minutes to form the current injection region 130A of 5 m in diameter in the p-AlInAs layer 130. The manufactured laser device B showed a threshold current of 1.5mA in a room temperature, and emission was obtained in a temperature 85°C with Ith=5mA.

The above laser device showed a maximum optical output of 0.5mW in a room temperature, and a single transverse mode operation was observed. When 1km of ordinary single mode optical fiber was connected to the laser device and emitted laser light was transmitted at a transmission rate of 5bit/s, a clear eye pattern was obtained.

In manufacturing the laser device of the present invention, in place of the stacked structure B1 shown in FIG. 10, a stacked structure B1' may be used which, as shown in FIG. 19, includes a tunnel junction of n-InP/p-InP formed by forming a layer 170 of n-InP further on the cladding layer 160 of p-InP.

When the stacked structure B1' is used, the p type reflecting mirror layer structure does not need to be used. Therefore, the cost of manufacturing the laser device is reduced.

### Industrial Applicability

In the surface emitting semiconductor laser device of the present invention, the distance between the current blocking layer and the active layer is far shorter than that of the conventional one. Therefore, it operates with a lower threshold current and shows better temperature operation characteristics.

These are the effects produced by using, as material for the current blocking layer, AlInAs which is a compound semiconductor including Al and shows good lattice matching with the InP substrate in forming the stacked substrate B1.

## Claims

1. A surface emitting semiconductor laser device, comprising:
an active layer and a current blocking layer arranged near said active layer, both of said active layer and said current blocking layer being arranged between two reflecting mirror stacked structures; wherein
said current blocking layer is an AlInAs layer having an oxidized region formed at the peripheral portion thereof.

2. A surface emitting semiconductor laser device according to claim 1, wherein
said current blocking layer is arranged in a cladding layer arranged over or under said active layer.

3. A surface emitting semiconductor laser device according to claim 1, wherein
a p type cladding layer of 30nm to 250nm in thickness is arranged between said current blocking layer and the said active layer.
